Europäisches Patentamt

European Patent Office

Office européen des brevets

(11) Numéro de publication: **0 375 497**
**A1**

## (12) DEMANDE DE BREVET EUROPEEN

(21) Numéro de dépôt: **89403405.7**

(22) Date de dépôt: **08.12.89**

(51) Int. Cl.⁵· **H03D 1/22**

(30) Priorité: **20.12.88 FR 8816802**

(43) Date de publication de la demande:
**27.06.90 Bulletin 90/26**

(84) Etats contractants désignés:
**DE GB NL SE**

(71) Demandeur: **THOMSON COMPOSANTS MICROONDES**
**51, Esplanade du Général de Gaulle**
**F-92800 Puteaux(FR)**

(72) Inventeur: **Pataut, Gérard**
**THOMSON-CSF SCPI Cédex 67**
**F-92045 Paris la Défense(FR)**

(74) Mandataire: **Taboureau, James et al**
**THOMSON-CSF SCPI**
**F-92045 Paris La Défense Cédex 67(FR)**

(54) Dispositif pour la modulation ou la démodulation directe en hyperfréquences.

(57) L'invention concerne un circuit hyperfréquences destiné soit à la modulation directe, soit à la démodulation directe d'un signal de faisceau hertzien.

Il est caractérisé en ce que l'oscillateur local (8) est incorporé dans le circuit. L'oscillateur local fournit deux signaux qui sont en opposition de phases, à 180°. Chaque signal est adressé à un déphaseur. Le premier déphaseur (9) fournit deux signaux en quadrature, à 0° et 90°. Le second déphaseur fournit deux signaux en quadrature à 180° et 270°. Les signaux à 0° et 180° sont adressés sur un premier mélangeur (2), tandis que les signaux à 90° et 270° sont adressés sur un second mélangeur (3). Application aux faisceaux hertziens.

FIG.3

## DISPOSITIF POUR LA MODULATION OU LA DEMODUTATION DIRECTE EN HYPERFREQUENCES.

La présente invention concerne un dispositif de modulation et démodulation directe, en hyperfréquences. Ce dispositif, étudié pour être réalisé en circuit intégré, est plus particulièrement destiné au traitement de l'information dans les faisceaux hertziens.

Les circuits de modulation et de démodulation directe étant pratiquement les mêmes, à quelques détails près, l'invention sera exposée en s'appuyant sur l'exemple d'un démodulateur, de façon à clarifier l'exposé, et les détails relatifs à un modulateur seront fournis lorsque nécessaire.

La structure habituelle des circuits de réception des faisceaux hertziens numériques comporte toujours des circuits travaillant en fréquence intermédiaire. Les fonctions de ces circuits en fréquence intermédiaire sont la préamplification, le filtrage et l'amplification avec commande automatique de gain (CAG) qui permet de fournir au démodulateur cohérent un signal d'amplitude constante.

Le principe de la démodulation directe, qui est connu, est de reporter en bande de base les opérations en fréquence intermédiaire, et de régénérer dans la démodulation la fréquence porteuse modulée. Ceci permet de supprimer, par rapport à l'art connu, un certain nombre de circuits : coupleurs 3dB, déphaseurs 90°, oscillateur contrôlable en tension, amplificateur faible bruit à CAG, mélangeurs.

Dans une démodulation directe classique, un oscillateur local fournit un seul signal, qui alimente deux étages de déphaseurs. Un premier déphaseur en donne un signal en phase P (0°) et un signal en quadrature Q (90°). Dans le second étage interne au mélangeur, un second déphaseur transforme le signal en phase en deux signaux à 0° et 180° de déphasage, et un troisième déphaseur transforme le signal en quadrature en deux signaux à 90° et 270° de déphasage.

En outre, un démodulateur classique est généralement réalisé en technologie hybride, où les déphasages sont obtenus avec des lignes, dans différents modes de propagation : microbandes, lignes à fente, lignes coplanaires.

En technologie monolithique intégrée sur Arséniure de Gallium, les longueurs de lignes sont prohibitives et il faut avoir recours à d'autres schémas, à éléments localisés par exemple.

L'invention propose une structure différente de la tête de réception, mais respectant le même fonctionnement. L'oscillateur local (OL) fournit deux tensions exactement en opposition de phase. Chaque composante est divisée ensuite en quadrature avant d'être utilisée pour le mélange. Dans cette solution, le déphasage 0°-180° est généré par l'oscillateur local lui-même et il n'y a que deux déphasages 90° à implanter sur le circuit intégré au lieu de trois dans la structure classique (une fois 90° puis deux fois 180°).

Le circuit intégré comprenant ce nouveau démodulateur avec l'amplificateur faible bruit constitue un circuit de réception ayant moins de composants. Il est donc réalisable avec un meilleur rendement.

De plus, la structure selon l'invention peut être utilisée pour des modulateurs dans des circuits d'émission.

De façon plus précise, l'invention concerne un dispositif pour la modulation ou la démodulation directe en hyperfréquences, comportant deux mélangeurs qui délivrent (démodulation) ou reçoivent (modulation) le premier un signal en phase P(t) et le second un signal en quadrature Q(t), lesdits mélangeurs étant commandés le premier par deux signaux dont les phases sont 0° et 180°, et le second par deux signaux dont les phases sont 90° et 270°, ces quatre signaux étant fournis par deux déphaseurs , ce dispositif étant caractérisé en ce qu'il comporte un oscillateur local commandé par une tension, dit VCO, qui fournit deux signaux de sorties en opposition de phase, le premier signal $Vc1$ (t) en phase à 0° étant adressé au premier déphaseur, et le second signal $Vc2(t)$ en opposition de phase à 180° étant adressé au second déphaseur.

L'invention sera mieux comprise, et ses avantages ressortiront mieux de la description d'un exemple d'application, en conjonction avec les figures jointes en annexe, qui représentent :

- fig. 1 : schéma en diagramme de blocs d'un démodulateur selon l'art connu,

- fig. 2 : schéma d'implantation d'un récepteur selon l'art connu.

- fig. 3 : schéma en diagramme de blocs d'un démodulateur selon l'invention,

- fig. 4 : schéma d'implantation d'un récepteur selon l'invention,

- fig. 5 : schéma électrique de l'oscillateur fournissant deux signaux en quadrature, selon l'invention,

- fig. 6 : schéma électrique d'un déphaseur fournissant deux signaux en quadrature, selon l'invention,

- fig. 7 : schéma électrique du diviseur d'entrée du signal, pour un démodulateur selon l'invention,

- fig. 8 : schéma électrique du combineur de sortie, pour un modulateur selon l'invention,

- fig. 9 : schéma électrique de l'amplificateur faible bruit à contrôle de gain automatique.

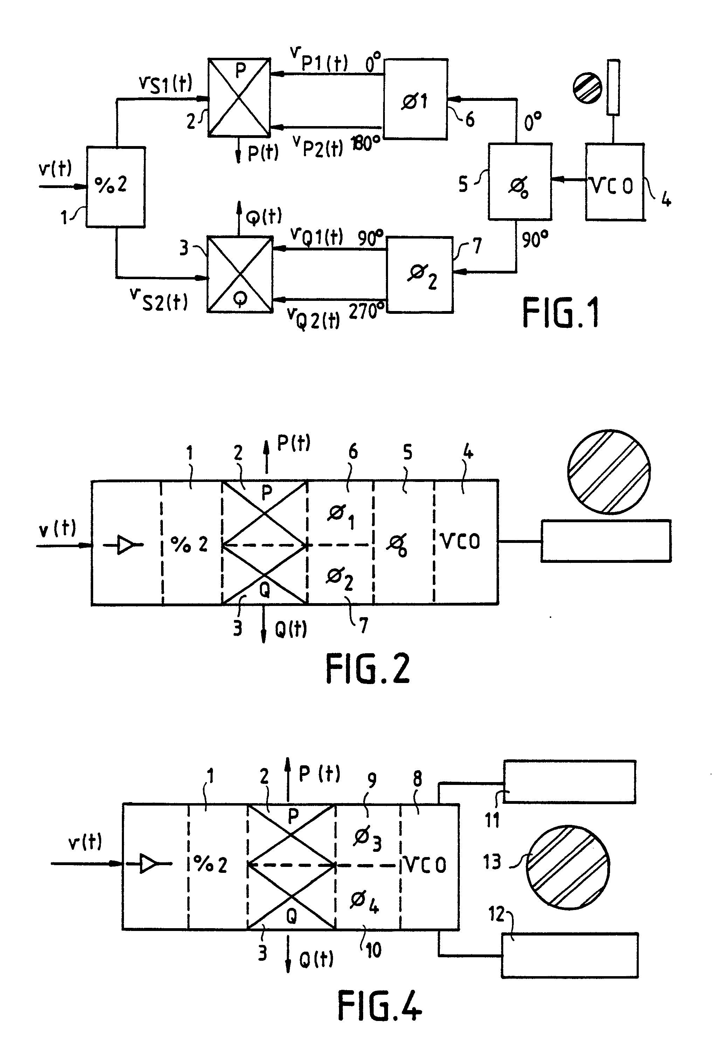

L'originalité de l'invention ressortira mieux par sa comparaison avec un circuit classique. Puisqu'un démodulateur a été choisi pour exposer l'invention, c'est également un démodulateur selon l'art connu qui est représenté en figure 1.

Il fait partie d'une chaine de traitement de l'information, dans laquelle la méthode de modulation utilisée est la modulation vectorielle, c'est à dire la modulation linéaire de l'amplitude de la porteuse et de sa composante en quadrature. Ainsi, dans le démodulateur, l'unique signal d'oscillateur local (OL) est divisé en deux composantes en quadrature entre les deux voies en phase (P) et en quadrature (Q). Dans chacune de ces deux voies, les mélangeurs peuvent être simples, doubles ou quadruples. Pour la démodulation directe, la nécessité de structures équilibrées conduit à introduire un déphasage d'OL de $0°$ à $180°$ entre chaque diode, pour un mélangeur à diodes.

Une tête de réception pour signaux à modulation vectorielle comporte donc sur le signal OL un premier déphasage $0-90°$, puis dans chacun des mélangeurs un déphasage $0-180°$. Ceci a pour résultat de réaliser sur le signal d'OL les quatre phases $0°, 180° 90°, 270°$.

Sur la figure 1, le signal d'entrée v(t) est appliqué sur un diviseur par 2, repéré 1, qui l'adresse à deux mélangeurs en phase P et en quadrature Q, repérés 2 et 3. La démodulation sera opérée au moyen d'un oscillateur 4, commandé en tension, connu sous le sigle VCO (Voltage Controlled Oscilator), asservi par une microbande et un résonateur diélectrique. L'unique signal de sortie du VCO est adressé à un premier déphaseur 5 qui en fournit le signal en phase $0°$ et le signal en quadrature $90°$.

Le signal en phase $0°$ est adressé à un deuxième déphaseur 6, qui en fournit le signal en phase $0°$ ($v_{P1}(t)$) et le signal en opposition de phase $180°$ ($v_{P2}(t)$). Ces deux signaux sont adressés au même mélangeur 2 de la voie en phase.

De façon symétrique, le signal en quadrature $90°$ est adressé à un troisième déphaseur 7, qui en fournit les signaux $90°$ et $270°$, adressés au même mélangeur 3 de la voie en quadrature.

Dans ce démodulateur, le signal d'entrée
$$v(t) = A \sin(\omega ot + \emptyset(t))$$ est divisé entre deux mélangeurs :
$$vs1(t) = A_P . \sin(\omega ot + \emptyset(t))$$
$$vs2(t) = A_Q . \sin(\omega ot + \emptyset(t))$$
$\emptyset(t)$ est la modulation transportée par la porteuse $\omega 0$.

Pour une modulation à 4 états de phase, la modulation s'écrit
$$\emptyset(t) = \pi/4 + k\pi/2 \text{ avec } k \in (0,1,2,3)$$

Le signal fourni par l'oscillateur local commandé en tension s'écrit :
$$V_{co}(t) = B \sin(\omega ot + \theta)$$ et après les deux types de déphasages $\emptyset_0$ et $\emptyset_1$ ou $\emptyset_2$, les quatre composantes sont :
$$v_{P1}(t) = B_{P1} . \sin(\omega ot + \theta)$$
$$v_{P2}(t) = B_{P2} . \sin(\omega ot + \theta + \pi)$$
$$v_{Q1}(t) = B_{Q1} . \sin(\omega ot + \theta + \pi/2)$$
$$v_{Q2}(t) = B_{Q2} . \sin(\omega ot + \theta + \pi/2 + \pi)$$
Il ressort du mélangeur P après filtrage :
$$P(t) = C_P . \cos\emptyset(t)$$
et du mélangeur Q :
$$Q(t) = C_Q . \sin\emptyset(t)$$
$C_P$ et $C_Q$ étant des coefficients.

A partir de ces deux trains d'ondes P(t) et Q(t), un régénérateur reconstitue le train d'informations transmises.

La figure 2 représente l'implantation d'un récepteur comprenant le dispositif de démodulation directe de la figure 1. Un récepteur est un démodulateur auquel sont adjoints un amplificateur faible bruit avec CAG et un oscillateur VCO. Qu'il soit réalisé en circuit hybride ou en circuit intégré, ce récepteur comporte trois déphaseurs 5,6,7.

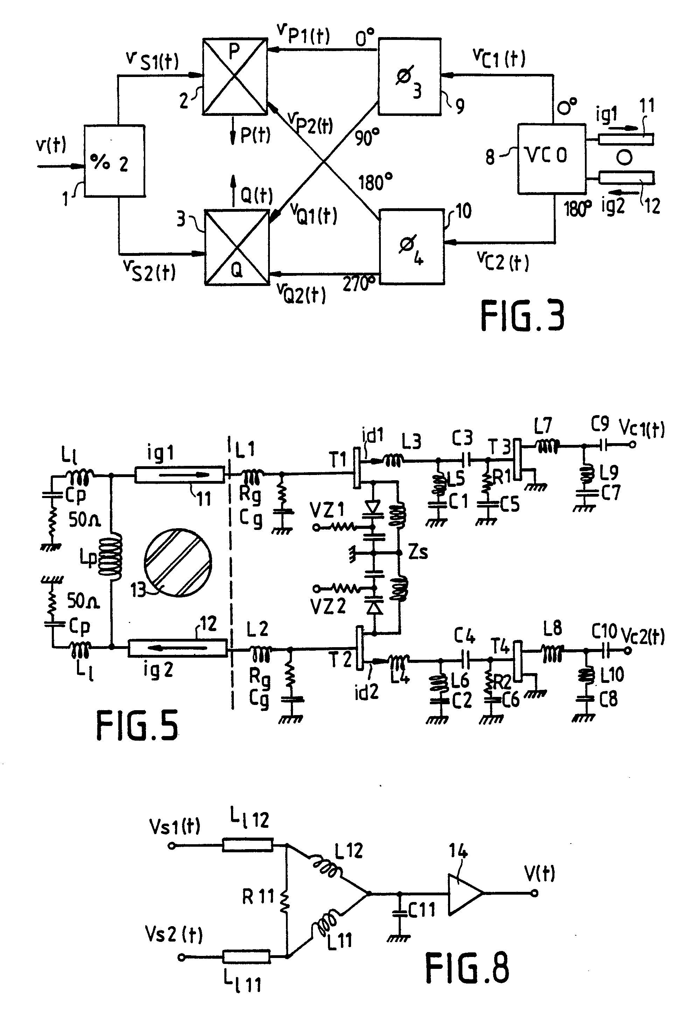

Le dispositif de démodulation directe selon l'invention est représenté en figure 3 : il ne comporte que deux déphaseurs 9 et 10, parce que l'oscillateur 8 est inclus dans le démodulateur et génère à l'origine deux signaux déphasés de $180°$. Les déphaseurs 9 et 10 génèrent deux signaux déphasés de $90°$.

Ainsi, tandis que dans l'art connu on avait un déphaseur 5 à $90°$ suivi de deux déphaseurs 6 et 7 à $180°$, dans l'invention on a un oscillateur 8 suivi de deux déphaseurs 9 et 10 à $90°$. Il s'ensuit que deux sorties, à $90°$ et à $180°$, des déphaseurs 9 et 10 sont permutées. Le déphaseur 9 attaque une entrée sur chacun de deux mélangeurs en phase P et en quadrature Q. Symétriquement, le déphaseur 10 attaque lui aussi une entrée sur chacun des deux mélangeurs.

L'oscillateur 8 fournit deux tensions en opposition de phase :
$$v_{c1}(t) = v_1 . \sin(\omega ot + \theta)$$
$$v_{c2}(t) = v_2 . \sin(\omega ot + \theta + \pi)$$
Ces deux tensions donnent elles-mêmes deux tensions en quadrature après les déphaseurs 9 et 10 :
$$v_{P1}(t) = B_{P1} . \sin(\omega ot + \theta)$$
$$v_{Q1}(t) = B_{Q1} . \sin(\omega ot + \theta + \pi)$$
$$v_{P2}(t) = B_{P2} . \sin(\omega ot + \theta + \pi)$$
$$v_{Q2}(t) = B_{Q2} . \sin(\omega ot + \theta + \pi + \pi/2)$$

On retrouve les quatre composantes de la structure classique de démodulateur. Ainsi, on obtient les mêmes trains d'ondes P(t) et Q(t) à la sortie du démodulateur. L'originalité de cette structure est d'intervertir les déphassages $90°$ et $180°$ et de ramener le déphasage $180°$ au niveau de l'oscillateur où il est aisément obtenu.

La figure 4, par comparaison avec la figure 2, permet de constater que le démodulateur selon l'invention est plus simple que celui de l'art connu, puisqu'il n'y a plus que deux déphaseurs, 9 et 10.

L'exposé de la structure de chaque partie du démodulateur va montrer que ce circuit se prête particulièrement bien à l'intégration, surtout sur matériaux III-V correspondant aux hyperfréquences, tel que GaAs.

L'oscillateur équilibré 0-180° est représenté en figure 5. C'est un oscillateur de type "push-push", dont le fonctionnement est en partie connu, par exemple de la demande de brevet français n° 86 08584 appartenant à la demanderesse. Mais l'oscillateur selon l'invention est modifié, par rapport à l'art connu, pour que les deux signaux de sorties soient en opposition de phase, au lieu d'obtenir un signal unique à fréquence doublée.

Tous les éléments de circuit à gauche de la ligne pointillée sont en technologie hybride. Ce sont deux lignes de propagation microstrip 11 et 12 sur substrat isolant terminées par des charges 50Ω. L'inductance $L_p$ reliant les deux lignes met en série les générateurs de bruit basse fréquence qui s'annulent. Entre les deux lignes, un résonateur diélectrique 13 est couplé simultanément aux deux lignes dans lesquelles circulent des courants de sens contraire, $ig_1$ et $ig_2$.

Tous les éléments de circuit à droite de la ligne pointillée sont réalisés en technologie circuit intégré sur Arséniure de Gallium. Ce sont d'abord les transistors $T_1$ et $T_2$ travaillant en oscillateur et dont les courants de drains $id_1$ et $id_2$ sont en opposition de phase puisque leurs courants de grilles $ig_1$ et $ig_2$ le sont aussi.

Une impédance de source, dénommée globalement Zs, réunit les sources des deux transistors T1 et T2. Elle est formée par deux diodes varactors, qui sont commandées par deux tensions Vz1 et Vz2 : ceci permet d'introduire un changement de fréquence nécessaire dans la démodulation.

Les transistors T3 et T4 fonctionnent en amplificateur présentant à T1 et T2 respectivement des impédances optimum pour l'oscillation. Ils assurent le niveau de sortie de chaque voie et l'isolation par rapport à l'utilisation (impédance de charge).

Ils fournissent respectivement les signaux en phase Vc1(t) et en opposition de phase Vc2(t), qui sont adressés aux déphaseurs 9 et 10.

Dans cet oscillateur, les signaux sont en opposition de phase par construction pourvu que les deux voies soient symétriques électriquement et géométriquement; la réalisation en circuit intégré sur Arséniure de Gallium de ces circuits répond bien à ces critères.

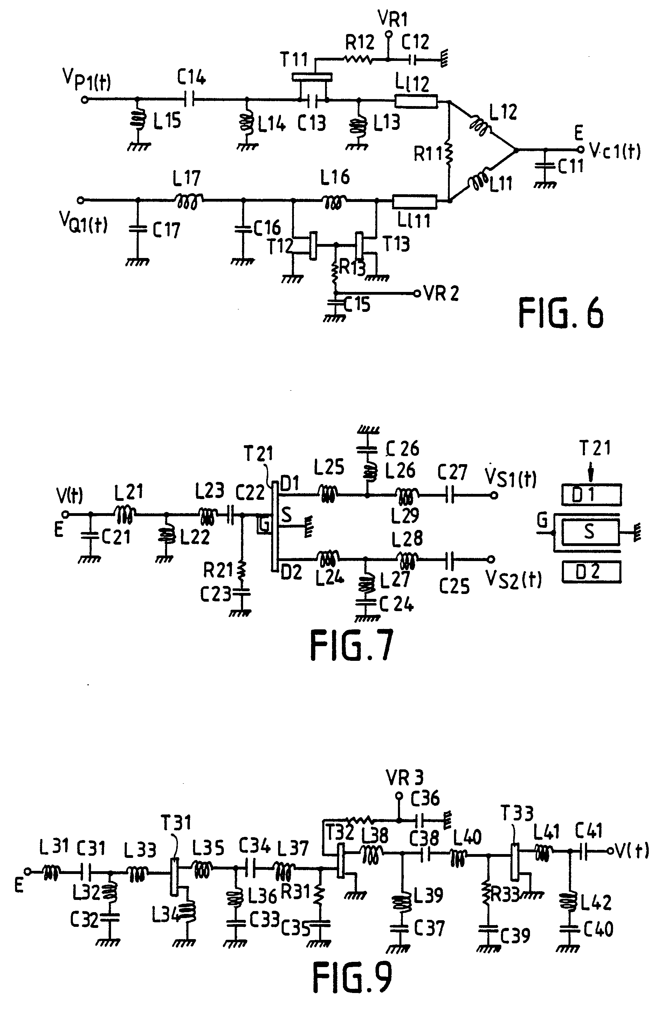

Les deux déphaseurs 9 et 10 sont du même type et fournissent en sortie deux signaux en quadrature : pour être plus précis, l'un des signaux est en avance de phase de 45° et l'autre en retard de phase de 45°, mais les deux signaux sont bien décalés de 90°. Le schéma électrique de l'un de ces déphaseurs est donné en figure 6.

A l'entrée E, le signal, Vc1(t) par exemple, est divisé en deux dans une structure de type Wilkinson à éléments localisés: C11, L11, L12, R11, Ll11,Ll12.

Dans une première voie, sur la partie supérieure de la figure 6, le circuit L13, L14, C13, T11, R12, C12 est une cellule à déphasage variable, contrôlée par la tension de grille du transistor T11 non polarisé. La tension de réglage VR1, agissant sur la grille de T11, fait que sa capacité, en parallèle avec C13, est plus ou moins faible. Le déphasage de cette voie est finalement obtenu en ajoutant le circuit L14, C14, L15.

Le signal VP1(t) qui sort de cette voie est déphasé de + 45° par rapport au signal Vc1(t) sur l'entrée E.

Dans une seconde voie, le circuit L16, T12, T13, R13, C15 est un atténuateur variable, utilisant deux transistors non polarisés. La tension de réglage VR2, appliquée entre R13 et C15, permet de régler l'atténuation. Un second circuit C16, L17, C17 permet d'obtenir en sortie un signal VQ1(t) déphasé de -45°, donc en quadrature avec le signal VP1(t) de la première voie.

L'égalité d'amplitude entre les deux voies est obtenue par les transistors T12 et T13, et le déphasage de 90° est réglé par le transistor T11, tous trois étant non-polarisés (Vds = 0 Volt).

Le diviseur d'entrée du dispositif de modulation ou démodulation directe peut être un diviseur connu, mais la figure 7 en présente un modèle original, qui a été conçu en vue de l'intégration, notamment sur GaAs.

Le principe en est d'appliquer le signal V(t) présent à l'entrée E et qui doit être divisé en deux signaux égaux, sur l'unique grille, mais à deux doigts, d'un transistor T21, à deux drains, dont le schéma est représenté en partie droite de la figure 7. Les deux drains séparés assurent les deux voies de sorties VS1(t) et VS2(t).

Si les éléments de circuits sont strictement identiques dans les deux voies, les signaux de sortie ont la même phase et la même amplitude. L'avantage de ce diviseur est que l'utilisation d'éléments actifs permet d'obtenir un gain dans chaque voie et une bonne isolation des deux voies par rapport à l'entrée.

L'invention a été exposée, jusqu'à présent, en s'appuyant sur le cas d'un démodulateur direct. Mais si elle est appliquée à un modulateur direct, le circuit diviseur de la figure 7 doit être remplacé par un circuit combineur représenté en figure 8.

Dans ce cas, les signaux d'entrées sont les signaux P(t) et Q(t) de la figure 3, et le combineur de la figure 8 combine en phase les deux voies modulées sortant des mélangeurs 2 et 3. Ce combineur n'est autre qu'un circuit de type Wilkinson, identique à celui inclus dans les déphaseurs 9 et 10.

Il est suivi d'un étage 14 de puissance à contrôle automatique de gain pour l'émission du signal modulé, qui remplace l'amplificateur faible bruit à l'entrée dans le cas de la démodulation.

Pour en revenir à un dispositif de démodulation directe, le schéma de l'amplificateur faible bruit à contrôle automatique de gain est donné en figure 9.

La structure de cet amplificateur est à trois étages ayant chacun une fonction particulière. Le premier étage (transistor T31) est adapté en entrée pour avoir un facteur de bruit faible. Le second étage (transistor T32) utilise un transistor bigrille; la polarisation de la seconde grille de ce transistor par une tension VR3 permet de contrôler le gain de cet étage. Le dernier étage (transistor T33) avec un transistor de grande largeur donnera pour l'amplificateur une réponse très linéaire, parce que le transistor T33 étant large, il fonctionne loin de son point de saturation.

Les mélangeurs 2 et 3 ne sont pas détaillés. Ils sont de structures connues, de type équilibré, et peuvent être réalisés avec des transistors ou des diodes.

Les dispositifs de modulation ou démodulation directe selon l'invention sont utilisés pour le traitement des signaux hyperfréquences, dans les faisceaux hertziens ou les radars par exemple. Ils sont précisés par les revendications suivantes.

## Revendications

1 - Dispositif pour la modulation ou la démodulation directe en hyperfréquences, comportant deux mélangeurs (2,3) qui délivrent (démodulation) ou reçoivent (modulation) le premier (2) un signal en phase P(t) et le second (3) un signal en quadrature Q(t), lesdits mélangeurs (2,3) étant commandés le premier (2) par deux signaux dont les phases sont 0° et 180°, et le second (3) par deux signaux dont les phases sont 90° et 270°, ces quatre signaux étant fournis par deux déphaseurs (9,10), ce dispositif étant caractérisé en ce qu'il comporte un oscillateur local (8) commandé par une tension dit VCO, qui fournit deux signaux de sorties en opposition de phase, le premier signal VC1(t) en phase à 0° étant adressé au premier déphaseur (9), et le second signal VC2(t) en opposition de phase à 180° étant adressé au second déphaseur (10).

2 - Dispositif selon la revendication 1, caractérisé en ce que les deux déphaseurs (9,10) fournissent chacun deux signaux en quadrature, les signaux VP1(t) et VQ1(t), respectivement à 0° et 90°, issus du premier déphaseur (9) étant adressés respectivement au premier (2) et au second (3) mélangeur.

3 - Dispositif selon la revendication 1, caractérisé en ce que l'oscillateur commandé par une tension (8) comporte deux transistors oscillateurs à effet de champ (T1, T2) montés en parallèle :
- dont les sources sont réunies par une impédance variable (Zs), constituée par deux varactors, commandés par deux tensions (Vz1,Vz2)
- dont les grilles sont commandées par un circuit constitué par deux lignes microbandes (11,12) couplées à un unique résonateur diélectrique (13), les courants (ig1, ig2) circulent dans les lignes microbandes (11,12) étant de sens inverses,
- dont les courants de drains (id1, id2) sont de ce fait en opposition de phases,
ledit oscillateur comportant également deux autres transistors amplificateurs (T3, T4), un par voie de sortie, dont les grilles sont commandées par les courants de drain (id1, id2) des transistors oscillateurs (T1, T2).

4 - Dispositif selon la revendication 1, caractérisé en ce que chacun des deux déphaseurs (9,10) est constitué par :
- une structure de type Wilkinson à éléments localisés (C11, L11, L12, R11, LI11, LI12), qui reçoit sur son entrée (E) un signal (Vc1(t)) issu de l'oscillateur (8) et le divise en deux signaux, adressés :
- l'un sur une première voie en phase (VP1(t)), qui comprend un circuit à déphasage variable contrôlé par un transistor (T11) non polarisé, commandé par une tension de réglage (VR1), et un circuit de déphasage fixe,
- l'autre sur une seconde voie en quadrature (VQ1-(t)), qui comprend un circuit d'atténuation variable contrôlé par deux transistors (T12 , T13) non polarisés, commandés par une tension de réglage (VR2), et un circuit de déphasage fixe,
les deux tensions de réglage permettant de régler l'égalité d'amplitude et le déphasage à 90° dans les deux voies.

5- Dispositif selon la revendication 1, caractérisé en ce que, si ledit dispositif est un démodulateur, le diviseur par deux (1) est constitué par un transistor à effet de champ (T21) a une seule grille à deux doigts, et à deux drains séparés, la source étant mise à la masse.

6 - Dispositif selon la revendication 1, caractérisé en ce que, si ledit dispositif est un modulateur, le combineur est une structure de type Wilkinson, qui reçoit sur ses deux entrées les signaux (VS1, VS2) issus des mélangeurs (2,3), et fournit sur sa sortie un signal modulé.

FIG.1

FIG.2

FIG.4

FIG.3

FIG.5

FIG.8

FIG. 6

FIG.7

FIG.9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PHILIPS JOURNAL OF RESEARCH, vol. 41, no. 3, 1986, pages 219-231, Eindhoven, NL; R.A. BROWN et al.: "Some features of signal demodulation resulting from the practical implementation of a direct conversion radio receiver" * Figure 1 * --- | 1 | H 03 D    1/22 |
| A | IEEE GALLIUM ARSENIDE INTEGRATED CIRCUIT SYMPOSIUM, Portland, Oregon, 13-16 octobre 1987, pages 227-230, IEEE, New York, US; K.W. LEE et al.: "Push-push, frequency-doubling, MMIC oscillators" * Page 227, colonne de droite, lignes 10-23; page 228, colonne de gauche, lignes 17-22 * --- | 3 | |
| A | G. GONZALEZ: "Microwave transistor amplifiers analysis and design", 1984, pages 180-183, Prentice-Hall, Inc., Englewood Cliffs, NJ, US * Figure 4.7.8 * --- | 4,6 | **DOMAINES TECHNIQUES RECHERCHES (Int. Cl.5)** |
| A | FR-A-2 358 025 (NIPPON GAKKI SEIZO K.K.) * Figures 3,5 * ----- | 5 | H 03 D H 03 B H 01 L H 03 C |

Le présent rapport a été établi pour toutes les revendications

| Lieu de la recherche | Date d'achèvement de la recherche | Examinateur |
|---|---|---|
| LA HAYE | 28-03-1990 | PEETERS M.M.G. |